# EUROPÄISCHE PATENTSCHRIFT

(11) **EP 0 418 344 B1**
(45) Veröffentlichungstag und Bekanntmachung des Hinweises auf die Patenterteilung: **15.09.1993**
(21) Anmeldenummer: 90904354.9
(22) Anmeldetag: 15.03.1990
(51) Int. Cl.: G01B 9/02, H01S 3/133, H01S 3/139, H01S 3/081

(54) **EINRICHTUNG ZUR ERZEUGUNG VON LICHT**
LIGHT-GENERATION DEVICE
DISPOSITIF GENERATEUR DE LUMIERE

(30) Priorität: 21.03.1989 AT 651/89
(43) Veröffentlichungstag der Anmeldung: 27.03.1991
(73) Patentinhaber: Tabarelli, Werner, Dr., 9494 Schaan (LI)
(72) Erfinder: LEUCHS, Gerhard, CH-9478 Azmoos (CH); LAZECKI, René, CH-9470 Buchs (CH)
(74) Vertreter: Hofinger, Engelbert, DDr.
(86) Internationale Anmeldenummer: EP9000424
(87) Internationale Veröffentlichungsnummer: WO9011485

(56) Entgegenhaltungen:
- WO-A-88/06711
- Feinwerktechnik & Messtechnik, vol. 87, No. 8, 1979, (München, DE), M. Kerner : "Wellenlängenstabilisation", pages 368-372
- Applied Physics Letters, vol. 53, No. 11, 12 September 1988, American Institute of Physics, (New York, NY, US), L. Hollberg et al. : "Modulatable narrow-linewidth semiconductor lasers", pages 944-946

## Beschreibung

Die Erfindung betrifft eine Einrichtung zur Erzeugung von Licht, insbesondere für ein Interferometer zur Längenmessung, wobei die Frequenz des emittierten Laserlichtes in Abhängigkeit von der im gasförmigen Umgebungsmedium vorliegenden Wellenlänge derart geregelt ist, daß die im Umgebungsmedium vorliegende Wellenlänge konstant bleibt.

Bei Interferometern zur Lagebestimmung von beweglichen Bauteilen ist es von entscheidender Bedeutung, die Wellenlänge des verwendeten Laserlichtes im Umgebungsmedium (im folgenden kurz Luftwellenlänge genannt) genau zu kennen, da die Verschiebewege in Einheiten von dieser Luftwellenlänge vorliegen. Kennt man die Frequenz der Lichtwelle hinreichend genau, so besteht die Möglichkeit, die Luftwellenlänge durch eine Ermittlung der Brechzahl zu bestimmen. Die Brechzahl kann beispielsweise nach der Parametermethode bestimmt werden, bei der Temperatur, Luftdruck und Feuchte der Luft gemessen werden und dann die Brechzahl formelmäßig berechnet wird. Allerdings hat dieses Parameterverfahren den Nachteil, daß wichtige Einflußgrößen wie beispielsweise die Gaszusammensetzung nicht eingehen und scheidet daher bei der Anwendung des Interferometers in Werkstätten bzw. im Freien aus.

Es ist bereits auch eine Einrichtung bekannt geworden (Artikel "Wellenlängenstabilisation" von M. Kerner, Feinwerk & Meßtechnik, 87(1979)8, Seiten 368 - 372, bei der die Luftwellenlänge mit einem offenen Etalon erfaßt wird und die Frequenz der Lichtquelle in Abhängigkeit von der Brechzahl der Luft derart verstellt wird, daß die für die interferometrische Messung relevante Luftwellenlänge konstant bleibt. Bei der bekannten Einrichtung wird ein Helium-Neon-Laser als Lichtquelle verwendet. Die Variation der Frequenz des emittierten Laserlichtes ist durch Veränderung der Länge des Laserresonators etwa mittels Erwärmung und Kühlung oder durch Ausnützung des Piezo-effektes möglich.

Abgesehen von der relativ hohen Leistungsaufnahme und der Größe eines Helium-Neon-Lasers weist dieser insbesondere den Nachteil auf, daß der Frequenzverstellbereich lediglich ausreicht, um Brechzahlschwankungen in der Größenordnung von Δ n ≈ 2.10⁻⁶ zu erfassen, während die in der Praxis auftretenden Brechzahlschwankungen weit höher sind, nämlich bis in den Bereich Δ n ≈ 10⁻⁴ reichen können.

In der WO-A-88/06711 ist ein Interferometer beschrieben, das neben einem Meßinterferometer ein Referenzinterferometer zur Erfassung von Bruchzahländerungen und damit von Änderungen der im Umgebungsmedium vorliegenden Wellenlänge aufweist. eine elektronische Regelung soll die Temperatur und den Injektionsstrom der als Lichtquelle vorgesehenen Laserdiode in der Frequenz so vorstellen, daß die Wellenlänge im Umgebungsmedium konstant bleibt. Ein Problem besteht dabei darin, daß sich Laserdioden allein über die Temperatur und Injektionsstrom nur in einem geringen Bereich in der Frequenz stetig durchstimmen lassen. Darüberhinaus treten durch Modensprünge sprunghafte, unstetige Frequenzverläufe auf, die bei größeren Brechzahlschwankungen keine Konstanthaltung der im Umgebungsmedium vorliegenden Wellenlänge erlauben.

Aufgabe der Erfindung ist es, eine Einrichtung zur Erzeugung von Licht, insbesondere für Interferometer zur Längenmessung zu schaffen, die in der Lage ist, die Wellenlänge im Umgebungsmedium durch stetige Frequenzänderung bei den in der Praxis auftretenden Brechzahlschwankungen (in der Größenordnung von Δ n ≈ 10⁻⁴) konstant zu halten. Außerdem soll die Einrichtung eine kompakte Baugröße, insbesondere eine kleine Lichtquelle und gegebenenfalls die Möglichkeit eines Batteriebetriebes aufweisen.

Erfindungsgemäß wird dies bei einer Einrichtung der eingangs genannten Art dadurch erreicht, daß die Lichtquelle eine Laserdiode ist und daß außerhalb des Laserresonators der Laserdiode eine Einrichtung zur frequenzselektiven Rückkopplung von von der Laserdiode ausgesandtem Licht in den Laserresonator vorgesehen ist, wobei die von der frequenzselektiven optischen Rückkopplungseinrichtung im Bereich der Emissionsfrequenz der Laserdiode bevorzugt zurückgekoppelte Frequenz in Abhängigkeit von der im Umgebungsmedium vorliegenden Wellenlänge bzw. Brechzahl derart variiert, daß dadurch die im Umgebungsmedium vorliegende Wellenlänge auf einen konstanten Wert geregelt ist.

Die frequenzselektive optische Rückkopplung in Laserdioden ist an sich bekannt, beispielsweise aus Applied Physics Letters, Band 53, Nr.11, 12.Sept.1988, American Institute of Physics, (New York, NY, US), L.Hollberg et al.: "Modulatable narrow linewidth semiconductor lasers"; Seiten 944-946. In diesem Artikel geht es darum, mittels frequenzselektiver optischer Rückkopplung die Frequenz zu stabilisieren und die Linienbreite zu reduzieren. Der Artikel spricht zwar von der Möglichkeit einer geringfügigen Modulation der Emissionsfrequenz über den Injektionsstrom der Laserdiode. Diese kleinhubige, periodische Veränderung der Emissionsfrequenz der Laserdiode hat jedoch nichts mit der über einen großen Bereich durchstimmbaren, gezielten Veränderung der Emissionsfrequenz in Abhängigkeit von der Brechzahl des Umgebungsmediums zu tun. Mit anderen Worten offenbart der genannte Artikel keine durchstimmbare Lichtquelle, sondern eine in der Frequenz durch einen externen Resonator stabilisierte Lichtquelle. er gibt keinen Hinweis darauf, daß durch eine Veränderung der bevorzugt zurückgekoppelten Frequenz ein Mitziehen und damit Durchstimmen der Emissionsfrequenz der Laserdiode möglich wäre. Die Erfindung nutzt aber gerade aus, daß durch die dargestellte frequenzselektive Rückkopplung von Laserlicht es innerhalb bestimmter Grenzen möglich ist, die Emissionsfrequenz der als Lichtquelle dienenden Laserdiode bei Änderung der Lichtwellenlänge im Umgebungsmedium bzw. der Brechzahl so mit der bevorzugt zurückgekoppelten Frequenz "mitzuziehen", daß die Luftwellenlänge konstant bleibt, wobei bei dieser Vorgangsweise innerhalb des "Mitziehbereiches" auch der sonst bei Laserdioden übliche Effekt eines unstetigen (sprunghaften) Verlaufes der Emissionsfrequenz der Laserdiode über den Betriebsparametern (Injektionsstrom, Temperatur) unterbleibt.

Bei diesem "Mitziehen" der Laserdioden-Emissionsfrequenz innerhalb eines Regelbereiches nützt die erfindungsgemäße Einrichtung den an sich bekannten Effekt aus, daß frequenzselektiv rückgekoppeltes Licht den entsprechenden Emissionsfrequenz-Mode der Laserdiode derart verstärkt bzw. das unerwünschte Anschwingen von Neben-Moden so effektiv unterdrückt, daß es sogar möglich ist, die Lichtemission der Laserdiode auf jene Frequenz "einrasten" (Locking) zu lassen, die der von der frequenzselektiven Rückkopplungseinrichtung bevorzugt zurückgekoppelten Frequenz entspricht.

Im folgenden wird der Einfachheit halber häufig der Begriff "Luftwellenlänge" für die im gasförmigen Umgebungsmedium vorliegende Wellenlänge verwendet, da dieses Medium meist Luft sein wird.

Die Frequenzselektivität einer Rückkopplungseinrichtung kann dann gemäß einer bevorzugten Ausführungsform dadurch bewirkt werden, daß ein in Transmission oder Reflexion betriebenes Etalon fester Baulänge vorgesehen ist, zwischen dessen spiegelnden Flächen sich das Umgebungsmedium befindet, wobei zumindest ein Teil des vom Etalon frequenzselektierten Laserlichtes in den Laserresonator der Laserdiode zurückgekoppelt wird. Im Hinblick auf eine für den genannten Einrasteffekt günstige schmalbandige Rückkopplung ist ein in Transmission betriebenes Etalon besonders vorteilhaft. Bei dieser Ausführung variiert die vom Etalon im Bereich der Emissionsfrequenz der Laserdiode bevorzugt zurückgekoppelte Frequenz vorteilhafterweise automatisch in Abhängigkeit von der Brechzahl des Umgebungsmediums derart, daß sich durch den dargestellten Effekt die Emissionsfrequenz der Laserdiode in der Weise verschiebt, daß die Luftwellenlänge konstant bleibt.

Kennt man die Luftwellenlänge bzw. die Brechzahl des Umgebungsmediums (beispielsweise durch elektronisches Erfassen von Interferenzringen in einem offenen Luftwellenlängen-Erfassungsetalon), so ist grundsätzlich auch möglich, die bevorzugt in die Laserdiode zurückgekoppelte Frequenz und damit die darauf "einrastende" Emissionsfrequenz der Laserdiode dadurch zu verstellen, daß man in Abhängigkeit von Brechzahl bzw. Luftwellenlänge die Länge eines geschlossenen Etalons der Rückkopplungseinrichtung bzw. den Abstand dieses Etalons von der Laserdiode (beispielsweise piezoelektrisch oder elektrooptisch) variiert.

Gemäß einer bevorzugten Ausführungsform der Erfindung ist es günstig, wenn auch eine elektronische Regelungseinrichtung vorgesehen ist, die in Abhängigkeit von der im Umgebungsmedium vorliegenden Wellenlänge bzw. Brechzahl den Injektionsstrom und/oder die Temperatur der Laserdiode regelt. Zu Beginn einer Meßserie wird die elektronische Regeleinrichtung zunächst als Steuereinrichtung eingesetzt, um über Injektionsstrom und/oder Temperatur eine geeignete Anfangs-Emissionsfrequenz der Laserdiode anzusteuern, von der ausgehend dann bei sich ändernden Umweltbedingungen (Brechzahl) eine Frequenzregelung so erfolgt, daß die Luftwellenlänge konstant bleibt. Die Kriterien für diese Anfangs-Auswahl sind u.a. etwa ein möglichst geringer Energiebedarf für die Aufrechterhaltung der gewählten Betriebsparameter sowie ein möglichst großer Abstand zwischen zwei benachbarten Modesprüngen im Verlauf des Emissionsfrequenzen-Spektrums der Laserdiode über dem Injektionsstrom bzw. der Temperatur.

Die für die elektronische Regelung nötige Erfassung der im Umgebungsmedium vorliegenden Luttwellenlänge bzw. der Brechzahl kann mittels eines Etalons erfolgen, zwischen dessen Spiegelflächen sich das Umgebungsmedium befindet und dessen Interferenzmuster elektronisch ausgewertet wird. Nach der oben erwähnten Festlegung der Ausgangsbedingungen hat man mit der elektronischen Regeleinrichtung (eigentliche Regelfunktion) die Möglichkeit, die Betriebsparameter (Injektionsstrom, Temperatur) der Laserdiode in Abhängigkeit von der Luftwellenlänge zu regeln und damit das "Mitziehen" der Laserdioden-Emissionsfrequenz mit der aus der Rückkopplungseinrichtung bevorzugt zurückgekoppelten Frequenz zu unterstützen. Durch diese Kombination aus optischer Rückkopplungs -Regelung einerseits und elektronischer Regelung der Betriebsparameter der Laserdiode andererseits erreicht man, daß die Emissionsfrequenz über einen großen "Mitziehbereich" tatsächlich auf die bevorzugt zurückgekoppelte Frequenz eingerastet bleibt. An die Genauigkeit der elektronischen Regelung werden in diesem Falle keine allzu hohen Ansprüche gestellt, da ja die zur Konstanthaltung der Luftwellenlänge nötige Emissionsfrequenz innerhalb des "Mitziehbereiches" durch das von der frequenzselektiven Rückkoppelungseinrichtung zurückgekoppelte Signal festgelegt ist.

Insbesondere im Zusammenhang mit Multi-Mode-Laserdioden ist auch ein zweistufiges Verfahren möglich: dabei wird zunächst mittels eines nicht notwendigerweise mit dem Umgebungsmedium gefüllten Etalons, etwa einem soliden Glasetalon, das vorzugsweise dünner ist als die Länge des Laserresonators der Laserdiode, Licht zur Verstärkung des aktuell schwingenden bzw. zur Unterdrückung des Anschwingens benachbarter Moden frequenzselektiv optisch zurückgekoppelt; erst in einer zweiten Stufe (d.h. aus einem längeren Etalon) wird dann Licht jener Frequenz zurückgekoppelt, die zum "Mitziehen" bzw. "Einrasten" führen soll.
Der Rückkopplungseffekt hängt auch von der Entfernung des Etatons oder einer spiegelnden Fläche der Rückkopptungseinrichtung vom Laserresonator der Laserdiode ab. Dies kann ausgenutzt werden, um auch über die Entfernung des Etatons bzw. der spiegelnden Fläche von der Laserdiode eine Regelung der bevorzugt zurückgekoppelten Frequenz durchzuführen.

Weitere Einzetheiten der Erfindung werden in den folgenden Figurenbeschreibungen näher erläutert.

Es zeigen die Fig. 1 bis 3 schematisch dargestellte Ausführungsbeispiele der erfindungsgemäßen Einrichtung, bei der die Regelung der Emissionsfrequenz der Laserdiode durch eine reine optische Rückkopptung erfolgt, die Fig. 4 und 5 weitere Ausführungsbeispiele, bei denen eine elektronische Regelung zur Regelung der Betriebsparameter der Laserdiode in Abhängigkeit von den Umweltbedingungen vorgesehen ist, und die Fig. 6 und 7 zwei Ausführungsbeispiele, bei denen Licht in einen zweiten Ausgang der Laserdiode zurückgekoppelt wird.

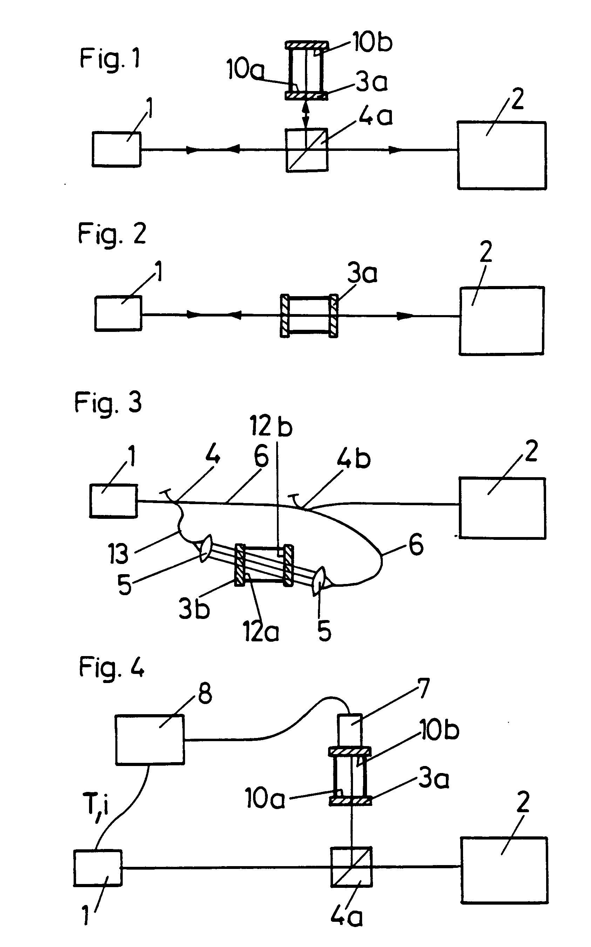

Die in Fig. 1 dargestellte Einrichtung zur Erzeugung von Licht besteht im wesentlichen aus einer Laserdiode 1, einem Strahlteiler 4a und einem Luftspalt-Etalon (Fabry-Perot-Interferometer) 3a, und dient zur Versorgung des allgemein mit der Bezugsziffer 2 bezeichneten Interferometers zur Längenmessung mit Licht, dessen Frequenz in Abhängigkeit von der im gasförmigen Umgebungsmedium vorliegenden Wellenlänge derart geregelt ist, daß die Luftwellenlänge konstant bleibt. Der konkrete Aufbau des Interferometers 2 zur Längenmessung kann je nach Anwendungsfall variieren. Beispielsweise kann das Interferometer einen Strahlteiler aufweisen, über den das aus der erfindungsgemäßen Einrichtung stammende Licht in einen Meßzweig und einen Referenzzweig aufgeteilt wird. Der längenveränderliche Meßzweig führt dabei durch das Umgebungsmedium und ist damit den Umwelteinflüssen ausgesetzt. Der von der Referenzstrecke zurückkehrende Referenzstrahl und der von der Meßstrecke zurückkehrende Meßstrahl werden zur Interferenz gebracht und das Interferenzsignal ausgewertet. Durch die erfindungsgemäße Konstanthaltung der Wellenlänge im Umgebungsmedium (Luftwellenlänge) ist sichergestellt, daß das zunächst in Einheiten der Luftwellenlänge vorliegende Meßergebnis auch korrekt in metrischen Einheiten bekannt ist.

Bei der in Fig. 1 dargestellten Ausführungsform der erfindungsgemäßen Einrichtung besteht die frequenzselektive Rückkopplungseinheit im wesentlichen aus dem offenen Etalon 3a, das in Reflexion betrieben ist und einen Spiegelabstand im Millimeterbereich aufweist. Bei einem solchen offenen Etalon befindet sich zwischen den Spiegelflächen 10a und 10b das Umgebungsmedium (im allgemeinen Luft). Ändert sich nun die Brechzahl des Umgebungsmediums und damit die Luftwellenlänge, so verändert sich die aus dem Etalon 3a über den Strahlteiler 4a bevorzugt in die Laserdiode 1 zurückgekoppelte Frequenz. Wenn die Laserdioden-Emissionsfrequenz (beispielsweise durch ausreichend starke und schmalbandige Rückkopplung) auf die zurückgekoppelte Frequenz einrastet, ist es damit möglich, die Laserdioden-Emissionsfrequenz innerhalb eines Regelbereiches mit der zurückgekoppelten Frequenz aus dem Etalon 3a "mitzuziehen". Dabei erfolgt die Verstellung der Frequenz durch das offene Etalon 3a gerade in einer solchen Weise, daß die Luftwellenlänge konstant bleibt. In der Praxis wird man das offene Etalon 3a möglichst in der Nähe der Meßstrecke des Interferometers 2 anordnen bzw. auf andere Weise sicherstellen, daß die Umweltbedingungen auf der Meßstrecke denen im Etalon 3a entsprechen.

Das in Fig. 2 dargestellte Ausführungsbeispiel unterscheidet sich im Hinblick auf die Rückkopplung aus einem in Reflexion betriebenen offenen Etalon kaum von dem in Fig. 1 gezeigten Beispiel. Allerdings tritt bei der in Fig. 2 dargestellten Ausführungsvariante das Licht für das Interferometer 2 durch das Etalon 3a hindurch. Bei der in Fig. 3 dargestellten Ausführungsform erfolgt die frequenzselektive Rückkopplung von von der Laserdiode 1 ausgesandtem Licht in den Laserresonator durch ein in Transmission betriebenes offenes Etalon 3b, zwischen dessen Spiegelflächen 12a, 12b sich das Umgebungsmedium befindet. Das Licht aus der Laserdiode kann dabei in Glasfasern 6 geführt sein. Über einen als Strahlteiler wirkenden Glasfaser-Koppler 4b gelangt ein Teil des Lichtes in das Meßinterferometer 2 und ein anderer Teil des Lichtes über die Auskoppellinse 5 in das Transmissions-Etalon 3b. Das durch das Etalon 3b in Abhängigkeit von der im Umgebungsmedium vorliegenden Wellenlänge bzw. Brechzahl in seiner bevorzugt zurückgekoppelten Frequenz variierende Licht wird über die Linse 5 in eine Glasfaser 13 eingekoppelt und gelangt von dort über den Glasfaser-Koppler 4 in den Laserresonator zurück. Durch die leichte Verkippung des Etalons 3b zur Lichtausbreitungsrichtung zwischen den beiden Linsen 5 erreicht man eine Vermeidung der Rückkopplung des reflektierten Signals. Mit in Transmission betriebenen Etalons ist eine besonders schmalbandige Rückkopplung in die Laserdiode 1 möglich, wobei das frequenzselektiv zurückgekoppelte Licht den entsprechenden Emissionsfrequenz-Mode der Laserdiode derart verstärkt bzw. das unerwünschte Anschwingen von Nebenmoden so effektiv unterdrückt, daß ein Einrasten der Emissionsfrequenz der Laserdiode auf die vom Etalon 3b bevorzugt zurückgekoppelte Frequenz genau gewährleistet ist.

Bei den in den Fig. 1 bis 3 dargestellten Ausführungsbeispielen verändert sich die bevorzugt zurückgekoppelte Frequenz durch die für das Umgebungsmedium offene Ausbildung der Etalone 3a bzw. 3b automatisch gerade so, daß die Luftwellenlänge konstant bleibt.

Ist die Luftwellenlänge bzw. die Brechzahl des Umgebungsmediums bekannt, so kann man auch eine aktive Verstellung der bevorzugt zurückgekoppelten Frequenz,auf die die Laserdioden-Emissionsfrequenz dann einrastet, vornehmen. Dies ist beispielsweise mit einem piezoelektrisch oder elektrooptisch längenverstellbaren Etalon oder durch eine Variation des Abstandes des Etalons (bzw. einer der Laserdiode zugewandten spiegelnden Fläche) von der Laserdiode möglich.

Bei dem in Fig. 4 dargestellten Ausführungsbeispiel ist zusätzlich zur frequenzselektiven Rückkopplung aus dem Etalon 3a in den Laserresonator der Laserdiode 1 eine elektronische Regeleinrichtung 8 vorgesehen, die in Abhängigkeit von der im Umgebungsmedium vorliegenden Wellenlänge bzw. Brechzahl den Injektionsstrom i und/oder die Temperatur T der Laserdiode regelt. Zur Erfassung der im Umgebungsmedium vorliegenden Wellenlänge kann ein Etalon vorgesehen sein, bei dem sich zwischen den Spiegelflächen das Umgebungsmedium befindet und dessen Interferenzmuster durch einen positionsempfindlichen Detektor, vorzugsweise eine Doppel- oder Quadrantendiode 7, erfaßt und elektronisch ausgewertet wird. Wie in Fig. 4 dargestellt, kann das Etalon zur Erfassung der Umgebungsparameter für die elektronische Regeleinrichtung 8 und das Etalon der frequenzselektiven optischen Rückkopplungseinrichtung durch ein und dasselbe Etalon 3a gebildet sein.

Wenn die Laserdiodenemissionsfrequenz durch eine effektive Rückkopplung auf die optisch zurückgekoppelte Frequenz einrastet, so sind an die Genauigkeit der elektronischen Regelung keine allzu hohen Ansprüche gestellt. Durch die Kombination aus optischer Rückkopplungsregelung einerseits und elektronischer Regelung der Betriebsparameter der Laserdiode andererseits erreicht man, daß die Emissionsfrequenz über einen großen "Mitziehbereich" tatsächlich auf die bevorzugt optisch zurückgekoppelte Frequenz eingerastet bleibt. Man verwendet in diesem Fall also die elektronische Regelung 8 dazu, um das "Mitziehen" der Laserdiodenemissionsfrequenz mit der aus der Rückkopplungseinrichtung bevorzugt zurückgekoppelten Frequenz zu unterstützen. Außerdem läßt sich eine solche elektronische Regeleinrichtung zu Beginn einer Meßserie zur Festlegung der Anfangs-Emissionsfrequenz der Laserdiode, von der aus dann die Konstanthaltung der Luftwellenlänge erfolgt, als Steuereinrichtung verwenden.

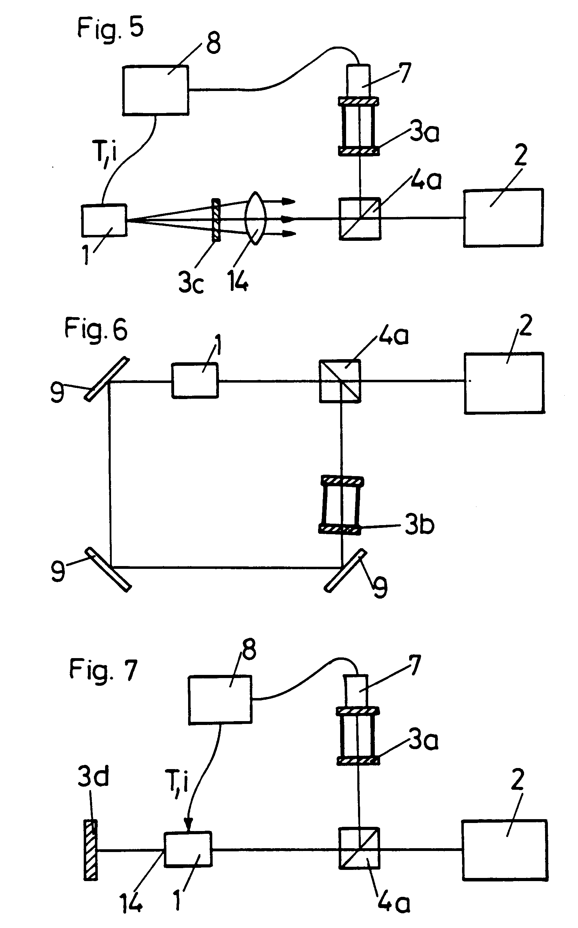

Um das Anschwingen von seitlichen Moden zu unterdrücken, kann (zur relativ breitbandigen frequenzselektiven Rückkopplung) auch ein solides Glasetalon 3c, dessen Dicke kleiner ist als die Länge des Laserresonators der Laserdiode, vorgesehen sein, wie dies in Fig. 5 dargestellt ist. Um gegen Verkippungen unempfindlich zu sein, ist das planparallele solide Glasetalon 3 c nahe der Laserdiode im divergent aus der Laserdiode austretenden Strahlbündel angeordnet, noch bevor dieses Strahlbündel in eine Kollimationsoptik 14 oder eine Einkopplungseinrichtung in eine Glasfaser gelangt.

Der Abstand des Glasetalons 3c von der Laserdiode 1 (und damit der als spiegelnde Fläche wirkenden, der Laserdiode zugewandten fläche des Glasetalons), welcher vorzugsweise in der Größenordnung und darunter liegt, kann auch regelbar sein, womit die bevorzugt zurückgekoppelte Frequenz im Bedarfstall veränderbar ist. Anstelle des Glasetalons 3c könnte eine solche abstands-variierbare spiegelnde Fläche nahe der Laserdiode auch von der Eintrittsfläche einer Kollimations- oder Fokussieroptik (z.B. für die Einkopplung in eine Glasfaser) gebildet sein.

Das in Fig. 6 dargestellte Ausführungsbeispiel entspricht im wesentlichen dem in Fig. 3 dargestellten Ausführungsbeispiel und verwendet ebenfalls ein leicht gekipptes, in Transmission betriebenes offenes Etalon 3b. Allerdings wird gemäß Fig. 6 das vom Etalon in Abhängigkeit von der im Umgebungsmedium vorliegenden Wellenlänge bzw. Brechzahl frequenzselektiv transmittierte Licht durch Spiegel 9 in den zweiten Ausgang der Laserdiode zurückgekoppelt.

Das in Fig. 7 dargestellte Ausführungsbeispiel stellt eine Variante von dem in Fig. 5 dargestellten Ausführungsbeispiel dar, wobei anstelle des dort verwendeten soliden Glasetalons 3c ein in einem Abstand vom zweiten Resonatorausgang 14 der Laserdiode 1 angeordneten Spiegel 3d vorgesehen ist. Der Spiegel 3d kann auch ein Glasplättchen-Etalon sein.

Die Erfindung ist selbstverständlich nicht auf die dargestellten Ausführungsbeispiele beschränkt. Insbesonders im Zusammenhang mit im Sichtbaren emittierenden Laserdioden, welche z.Z. Multi-Mode-Laserdioden sind, ist auch eine zweistufige optische Rückkopplung möglich. Dabei wird zunächst mittels eines nicht notwendigerweise mit dem Umgebungsmedium gefüllten Etalons, etwa einem soliden Glasetalon, das vorzugsweise dünner ist als die Länge des Laserresonators der Laserdiode, Licht zur Verstärkung des aktuell schwingenden Modes und zur Unterdrückung des Anschwingens benachbarter Moden frequenzselektiv optisch zurückgekoppelt (erste Stufe). Aus einem zweiten Etalon wird dann erst relativ schmalbandiges Licht zurückgekoppelt, das zum "Mitziehen" bzw. Einrasten der Laserdioden-Emissionsfrequenz führen soll (zweite Stufe).

Um eine automatische "Mitregelung" der Etalonlänge bzw. des Abstandes einer spiegelnden Fläche von der Laserdiode und damit der bevorzugt zurückgekoppelten Frequenz mit der Laserdiodentemperatur zu erzielen, kann gemäß einer bevorzugten Ausführungsform vorgesehen sein, daß die Laserdiode und das Etalon bzw. die spiegelnde Fläche der Rückkopplungseinrichtung thermisch gekoppelt sind und vorzugsweise die gleiche Temperatur aufweisen.

## Patentansprüche

1. Einrichtung zur Erzeugung von Licht, insbesondere für ein Interferometer zur Längenmessung, wobei die Frequenz des emittierten Laserlichtes in Abhängigkeit von der im gasförmigen Umgebungsmedium vorliegenden Wellenlänge derart geregelt ist, daß die im Umgebungsmedium vorliegende Wellenlänge konstant bleibt, dadurch gekennzeichnet, daß die Lichtquelle eine Laserdiode (1) ist und daß außerhalb des Laserresonators der Laserdiode (1) eine Einrichtung (3a, 3b, 3c, 3d; 4a, 4b; 5, 6, 13; 9) zur frequenzselektiven Rückkopplung von von der Laserdiode (1) ausgesandtem Licht in den Laserresonator vorgesehen ist, wobei die von der frequenzselektiven optischen Rückkopplungseinrichtung (3a, 3b, 3c, 3d,; 4a, 4b; 5, 6, 13; 9) im Bereich der Emissionsfrequenz der Laserdiode bevorzugt zurückgekoppelte Frequenz in Abhängigkeit von der im Umgebungsmedium vorliegenden Wellenlänge bzw. Brechzahl derart variiert, daß dadurch die im Umgebungsmedium vorliegende Wellenlänge auf einen konstanten Wert geregelt ist.

2. Einrichtung nach Anspruch 1, dadurch gekennzeichnet, daß die Rückkopplungseinrichtung ein Etalon (3a, 3b) fester Baulänge aufweist, zwischen dessen Spiegelflächen (10a, 10b; 12a, 12b) sich das Umgebungsmedium befindet, wobei zumindest ein Teil des vom Etalon (3a, 3b) frequenzselektierten Laserlichtes zurück in den Laserresonator gelangt.

3. Einrichtung nach Anspruch 2, dadurch gekennzeichnet, daß das Etalon (3b) in Transmission betrieben ist.

4. Einrichtung nach Anspruch 1, dadurch gekennzeichnet, daß die Rückkopplungseinrichtung ein in Abhängigkeit von der im Umgebungsmedium vorliegenden Wellenlänge bzw. Brechzahl längenverstellbares und damit in der bevorzugt in die Laserdiode zurückgekoppelten Frequenz verstellbares Etalon aufweist.

5. Einrichtung nach Anspruch 4, dadurch gekennzeichnet, daß das längenverstellbare Etalon eine planparallele Platte aus einem elektrooptischen Material ist, deren Oberflächen mit elektrisch leitenden, semitransparenten Beschichtungen versehen sind, so daß die optische Dicke des Etalons durch Anlegen einer elektrischen Spannung variierbar ist.

6. Einrichtung nach einem der Ansprüche 1 bis 5, dadurch gekennzeichnet, daß eine elektronische Regelungseinrichtung (8) vorgesehen ist, die in Abhängigkeit von der im Umgebungsmedium vorliegenden Wellenlänge bzw. Brechzahl den Injektionsstrom und/oder die Temperatur der Laserdiode (1) regelt.

7. Einrichtung nach Anspruch 6, dadurch gekennzeichnet, daß zur Erfassung der im Umgebungsmedium vorliegenden Wellenlänge ein Etalon (3a) vorgesehen ist, bei dem sich zwischen den Spiegelflächen (10a, 10b) das Umgebungsmedium befindet, wobei die elektronische Regeleinrichtung das Interferenzmuster des Etalons erfaßt und auswertet.

8. Einrichtung nach Anspruch 2 und 7, dadurch gekennzeichnet, daß das Etalon (3a) der optischen Rückkopplungseinrichtung und das Etalon (3a) zur Erfassung der im Umgebungsmedium vorhandenen Wellenlänge für die elektronische Regeleinrichtung (8) ein und dasselbe ist.

9. Einrichtung nach einem der Ansprüche 1 bis 8, dadurch gekennzeichnet, daß die frequenzselektive optische Rückkopplungseinrichtung wenigstens zwei verschieden lange Etalons (3b, 3c) oder ein Etalon und eine zusätzliche spiegelnde Fläche aufweist, aus denen Licht frequenzselektiv zurück in die Laserdiode gelangt.

10. Einrichtung nach Anspruch 1, dadurch gekennzeichnet, daß die Rückkopplungseinrichtung eine spiegelnde Fläche umfaßt, deren vorzugsweise in der Größenordnung der Laserresonatorlänge liegende oder noch kleinere Abstand vom Laserresonator variierbar ist.

11. Einrichtung nach Anspruch 10, dadurch gekennzeichnet, daß als spiegelnde Fläche die Eintrittsfläche der zur Kollimation oder Fokussierung des von der Laserdiode emittierten Lichtes benötigten Optik, vorzugsweise einer Gradienten-Index-Linse, verwendet wird.

12. Einrichtung nach Anspruch 1, dadurch gekennzeichnet, daß die Rückkopplungseinrichtung ein Etalon (3c) umfaßt, dessen vorzugsweise in der Größenordnung der Laserresonatorlänge liegender Abstand von der Laserdiode variierbar ist.

13. Einrichtung nach Anspruch 10 und 12, dadurch gekennzeichnet, daß das Etalon (3c) ein dünnes Plättchen aus durchsichtigem Material, vorzugsweise Glas, ist, dessen der Laserdiode (1) zugewandte Fläche die spiegelnde Fläche bildet und dessen Dicke geringer ist als die Resonatorlänge der Laserdiode.

14. Einrichtung nach einem der Ansprüche 1 bis 13, dadurch gekennzeichnet, daß als Lichtquelle eine im Sichtbaren emittierende Laserdiode verwendet wird.

15. Einrichtung nach einem der Ansprüche 1 bis 14, dadurch gekennzeichnet, daß als Lichtquelle eine Multi-Mode-Laserdiode verwendet wird, welche durch die frequenzselektive Rückkopplung lediglich auf einer Mode emittiert.

16. Einrichtung nach einem der Ansprüche 1 bis 15, dadurch gekennzeichnet, daß die Laserdiode und das Etalon bzw. die Etalone oder spiegelnden Flächen der Rückkopplungseinrichtung thermisch gekoppelt sind und vorzugsweise die gleiche Temperatur aufweisen.

17. Einrichtung nach einem der Ansprüche 1 bis 16, dadurch gekennzeichnet, daß über einen Resonatorspiegel aus der Laserdiode (1) austretendes Licht durch die frequenzselektive Rückkopplungseinrichtung (3b; 9; 3d) über den anderen Resonatorspiegel zurück in den Laserresonator gelangt.

## Claims

1. A device for generating light, in particular light for an interferometer for length measurements, whereby the frequency of the emitted laser light is controlled as a function of the wavelength existing in an ambient gaseous medium so that the wavelength in the ambient gaseous medium remains constant, characterized in that the light source is a laser diode (1), and that means (3a,3b,3c,3d; 4a,4b; 5,6,13; 9) are provided external to the laser resonator of the laserdiode (1) for a frequency selective feedback of light emitted by the laser diode (1) into the resonator, whereby the preferred feedback frequency lying in the range of the laser diode's emission-frequency from the optical feed back means (3a,3b,3c,3d; 4a,4b; 5,6,13; 9) varies as a function of the wavelength or refractive index existing in the ambient mediums so that the wavelength in the ambient medium is controlled to a constant value.

2. The device according to claim 1, characterized in that the feed back means comprises an etalon (3a,3b) of fixed total length between the mirrored surfaces (10a,10b; 12a,12b) of which the ambient medium is present, whereby at least a part of the emitted light, at selected frequencies, from the etalon (3a,3b) is fed back to the laser resonator.

3. The device according to claim characterized in that the etalon (3b) is operated in transmission.

4. The device according to claim 1, characterized in that the feedback means comprises an etalon of a length which is adjustable as a function of the wavelength or refractive index in the ambient gaseous medium, whereby by adjusting the length, the preferred feedback frequency of the light fed back to the laser diode is also adjusted.

5. The device according to claim 4, characterized in that the adjustable length etalon is a plane-parallel plate made of electro-optical material whose top surfaces are provided with electrically conductive, semi-transparent coating so that the optical thickness of the etalon is adjustable by applying an electrical voltage.

6. The device according to any one of claims 1 to 5, characterized in that an electronic control means (8) is provided for controlling the injection current and/or the temperature of the laser diode (1) as a function of the wavelength or refractive index in the ambient medium.

7. The device according to claim 6, characterized in that an etalon (3a) is provided for determination of the wavelength in the ambient medium, the ambient medium being comprised between the mirrored surface (10a,10b) of the etalon and the interference pattern being determined and electronically evaluated.

8. The device according to claim 2 and 7, characterized in that the etalon (3a) for the optical feed back means and the etalon (3a) for determination of the wavelength existing in the medium for the electronic control means (8) are the same.

9. The device according to any one of claims 1 to 8, characterized in that the feedback means comprises at least two different length etalons (3a,3b) or an etalon and an additional reflective surface, from which light is fed back to the laser diode at selected frequencies.

10. The device according to claim 1, characterized in that the feed back means comprises a mirrored surface which preferably lies at a distance from the laser resonator which is within the magnitude of the laser resonator's length or even smaller.

11. The device according to claim 10, characterized that the entry surface of an optical system required for collimating and focussing, preferably of a gradient index lens, is used as said mirrored surface.

12. The device according to claim 1, characterized in that the feed back means comprises an etalon (3c) whose distance from the laser diode is variable, the distance preferably being within the magnitude of the laser resonator length and even below.

13. A device according claim 10 and 12, characterized in that an etalon (3c) is a thin small plate made of transparent material, preferably glass, whose surface facing the laser diode (1) forms said mirrored surface and whose thickness is smaller than the length of the laser resonator.

14. The device according to any one of claims 1 to 13, characterized in that a laser diode emitting visible light is used as the light source.

15. A device according to any one of claims 1 to 14, characterized in that a multi-mode-laser diode is used as the light source which through the feeding back at selected frequencies emits solely a single mode.

16. The device according to any one of claims 1 to 15, characterized in that the laser diode and the etalon or the etalons or reflective surfaces of a feed back device are thermally coupled and preferably have the same temperature.

17. The device according to any one of claims 1 to 16, characterized in that light emitted by the laser diode (1) through a first resonator mirror is feed back by means of the feedback means (3b;9;3d) via a second resonator mirror into the laser resonator.

## Revendications

1. Dispositif générateur de lumière, en particulier pour un interféromètre de mesure de longueurs, la fréquence de la lumière laser émise étant réglée en fonction de la longueur d'onde présente dans le milieu gazeux de telle manière que la longueur d'onde présente dans le milieu reste constante, **caractérisé** en ce que la source lumineuse est une diode laser (1) et qu'il est prévu à l'extérieur de la cavité laser de la diode laser (1) un dispositif (3a, 3b, 3c, 3d ; 4a, 4b ; 5, 6, 13 ; 9) de réinjection sélective en fréquence dans la cavité laser, de lumière émise par la diode laser (1), la fréquence réinjectée de préférence par le dispositif optique de réinjection sélective en fréquence (3a, 3b, 3c, 3d ; 4a, 4b ; 5, 6, 13 ; 9) dans la gamme de la fréquence d'émission de la diode laser variant en fonction de la longueur d'onde ou de l'indice de réfraction présent dans le milieu de telle manière que la longueur d'onde présente dans le milieu soit ainsi réglée à une valeur constante.

2. Dispositif selon la revendication 1, **caractérisé** en ce que le dispositif de réinjection présente un étalon (3a, 3b) de longueur fixe entre les surfaces spéculaires (10a, 10b ; 12a, 12b) duquel se trouve le milieu, une partie au moins de la lumière laser sélectionnée en fréquence par l'étalon (3a, 3b) retournant dans la cavité laser.

3. Dispositif selon la revendication 2, **caractérisé** en ce que l'étalon (3b) fonctionne par transmission.

4. Dispositif selon la revendication 1, **caractérisé** en ce que le dispositif de réinjection présente un étalon réglable en longueur en fonction de la longueur d'onde ou de l'indice de réfraction présent dans le milieu et partant réglable dans la fréquence réinjectée de préférence dans la diode laser.

5. Dispositif selon la revendication 4, **caractérisé** en ce que l'étalon réglable en longueur est une plaque à faces planes et parallèles constituée d'un matériau électro-optique dont les surfaces sont munies de revêtements électroconducteurs semi-transparents si bien que l'on peut faire varier l'épaisseur optique de l'étalon en appliquant une tension électrique.

6. Dispositif selon l'une des revendications 1 à 5, **caractérisé** en ce qu'il est prévu un dispositif de réglage (8) électronique qui règle le courant d'injection et/ou la température de la diode laser (1) en fonction de la longueur d'onde ou de l'indice de réfraction présent dans le milieu.

7. Dispositif selon la revendication 6, **caractérisé** en ce que pour déterminer la longueur d'onde présente dans le milieu, il est prévu un étalon (3a) dans lequel le milieu se trouve entre les surfaces spéculaires (10a, 10b), le dispositif de réglage électronique détectant et exploitant le dessin d'interférence de l'étalon.

8. Dispositif selon les revendications 2 et 7, **caractérisé** en ce que l'étalon (3a) du dispositif optique de réinjection et l'étalon (3a) de détection de la longueur d'onde présente dans le milieu pour le dispositif de réglage électronique (8) constituent un seul et même étalon.

9. Dispositif selon l'une des revendications 1 à 8, **caractérisé** en ce que le dispositif optique de réinjection sélective en fréquence présente au moins deux étalons (3b, 3c) de différentes longueurs ou un étalon et une surface spéculaire supplémentaire à partir desquels la lumière est réinjectée dans la diode laser de manière sélective en fréquence.

10. Dispositif selon la revendication 1, **caractérisé** en ce que le dispositif de réinjection comprend une surface spéculaire dont l'écartement par rapport à la cavité laser qui est de préférence de l'ordre de la longueur de la cavité laser ou plus petit, peut varier.

11. Dispositif selon la revendication 10, **caractérisé** en ce que l'on utilise comme surface spéculaire la surface d'entrée de l'optique nécessaire pour la collimation ou la focalisation de la lumière émise par la diode laser, de préférence d'une lentille à gradient d'index.

12. Dispositif selon la revendication 1, **caractérisé** en ce que le dispositif de réinjection comprend un étalon (3c) dont l'écartement par rapport à la diode laser qui est de préférence de l'ordre de la longueur de la cavité laser, peut varier.

13. Dispositif selon les revendications 10 et 12, **caractérisé** en ce que l'étalon (3c) est une plaquette mince en matériau transparent, de préférence en verre, dont la surface tournée vers la diode laser (1) forme la surface spéculaire et dont l'épaisseur est inférieure à la longueur de la cavité de la diode laser.

14. Dispositif selon l'une des revendications 1 à 13, **caractérisé** en ce que la source lumineuse utilisée est une diode laser émettant dans le visible.

15. Dispositif selon l'une des revendications 1 à 14, **caractérisé** en ce que la source lumineuse utilisée est une diode laser multimode qui émet uniquement sur un mode du fait de la réinjection sélective en fréquence.

16. Dispositif selon l'une des revendications 1 à 15, **caractérisé** en ce que la diode laser et l'étalon ou les étalons ou surfaces spéculaires du dispositif de réinjection sont couplés thermiquement et présentent de préférence la même température.

17. Dispositif selon l'une des revendications 1 à 16, **caractérisé** en ce que la lumière sortant de la diode laser (1) est réinjectée dans la cavité laser par le dispositif de réinjection sélectif en fréquence (3b ; 9 ; 3d) par l'intermédiaire de plusieurs miroirs de cavité.
